# EUROPEAN PATENT APPLICATION

(11) **EP 2 180 762 A1**
(43) Date of publication of application: **28.04.2010**
(21) Application number: 08791280.4
(22) Date of filing: 17.07.2008
(51) Int. Cl.: H05B 33/04, H01L 51/50, H05B 33/10

(54) **ORGANIC ELECTROLUMINESCENT DEVICE AND METHOD FOR MANUFACTURING THE SAME**

(30) Priority: 31.07.2007 JP 2007200097
(71) Applicant: Sumitomo Chemical Company, Limited, Tokyo 104-8260 (JP)
(72) Inventor: ITO, Norihito, Misato-shi Saitama 341-0012 (JP); MORISHIMA, Shinichi, Tsukuba-shi Ibaraki 305-0047 (JP)
(74) Representative: Jackson, Martin Peter
(86) International application number: PCT/JP2008/062926
(87) International publication number: WO 2009/016970

(57) **Abstract**

An object of the present invention is to obtain an organic EL device having excellent light resistance and a method for manufacturing the same. An organic EL device comprises: a first substrate as a supporting substrate; a first electrode provided on the first substrate; an organic layer that is provided on the first electrode and includes at least an organic light-emitting layer; a second electrode provided on the organic layer; a resin layer provided to cover the first substrate and the second electrode thereon, the resin layer containing, at least in a region on the organic layer, an ultraviolet light absorber that absorbs ultraviolet light; and a second substrate arranged on the resin layer to block the organic layer from ambient air.

## Description

### TECHNICAL FIELD

The present invention relates to an organic electroluminescent device (hereinafter, also referred to as "organic EL device") and a method for manufacturing the same.

### BACKGROUND ART

An organic electroluminescent element (hereinafter, also referred to as "organic EL element") has various advantages in that the organic EL element can be driven with a lower voltage as compared to an inorganic EL element, and has high luminance and easily generates light of many different colors. Therefore, to obtain an organic EL element having excellent performance, various studies have been made.

A light emitting layer and other organic layers in the organic EL element are generally sensitive to ultraviolet light. That is, the organic layers in the organic EL element are more likely to deteriorate due to ultraviolet light as compared to an inorganic EL element. In the organic EL element, deterioration of the organic layers directly leads to deterioration of the properties of the organic EL element itself.

With respect to the organic EL device having a structure such that it has an organic layer sandwiched between a supporting substrate and a sealing substrate, and having a bottom emission structure in which light is emitted from the supporting substrate side, to reduce the effect of ultraviolet light coming from the light emission side (supporting substrate side), an ultraviolet protective film is attached on the surface of the supporting substrate, thereby improving the light resistance.

Further, in recent years, an organic EL device having a structure such that it has an organic layer sandwiched between a supporting substrate and a sealing substrate, and having a top emission structure such that light is emitted from a side opposite to the supporting substrate (sealing substrate side) has been proposed (see, for example, Patent Document 1). Like the organic EL device having a bottom emission structure, in the organic EL device having a top emission structure, to reduce the effect of ultraviolet light coming from the light emission side (sealing substrate side), an ultraviolet protective film is attached on the surface of the sealing substrate, thereby the light resistance can be improved. However, when using an ultraviolet protective film, a step of attaching the ultraviolet protective film on the surface of the substrate is required, and therefore the use of the ultraviolet protective film is unfavorable from the viewpoint of the manufacturing process for the device. Thus, studies have been made on a technique in which an ultraviolet light absorber is mixed into the light emitting layer in the organic EL layer to improve the light resistance.

Patent Document 1: Japanese Patent Application Laid-open No. H10-294182

### DISCLOSURE OF INVENTION

### PROBLEM TO BE SOLVED BY THE INVENTION

However, in the conventional technique described above, when an ultraviolet light absorber is mixed into the light emitting layer, the light emitting layer generally has a thickness of about 2 to 200 nanometers, and the amount of the ultraviolet light absorber which may be included in such a thin light emitting layer is limited, so that the light emitting layer including the absorber cannot absorb a satisfactory amount of ultraviolet light.

The present invention has been achieved in view of the above problems, and an object of the invention is to obtain an organic EL device having excellent light resistance and a method for manufacturing the same.

### MEANS FOR SOLVING PROBLEM

To solve the problems described above and achieve an object, an organic EL device of the present invention is characterized by comprising: a first substrate as a supporting substrate; a first electrode provided on a mounting surface of the first substrate; an organic layer that is provided on the first electrode and includes at least an organic light-emitting layer; a second electrode provided on the organic layer; a resin layer that contains an ultraviolet light absorber, and is provided over the second electrode to cover at least a region superimposed over the organic layer; and a second substrate that covers the resin layer and encloses the organic layer with the first substrate to block the organic layer from ambient air. The present invention provides the following organic EL device and method for manufacturing the same.
[1] An organic electroluminescent device comprising:
   a first substrate as a supporting substrate;
   a first electrode provided on a mounting surface of the first substrate;
   an organic layer that is provided on the first electrode and includes at least an organic light-emitting layer;
   a second electrode provided on the organic layer;
   a resin layer that contains an ultraviolet light absorber, and is provided over the second electrode to cover at least a region superimposed over the organic layer; and
   a second substrate that covers the resin layer and encloses the organic layer with the first substrate to block the organic layer from ambient air.
[2] The organic electroluminescent device according to the above [1], having a top emission structure in which light generated by the organic light-emitting layer is emitted from a side of the second substrate.
[3] The organic electroluminescent device according to the above [1] or [2], wherein the resin layer contains a space adjusting member that adjusts a space between the first substrate and the second substrate.
[4] An organic electroluminescent device comprising:
   a first substrate as a supporting substrate;
   a first electrode provided on a mounting surface of the first substrate;
   an organic layer that is provided on the first electrode and includes at least an organic light-emitting layer;
   a second electrode provided on the organic layer; and
   a sealing film having a region that contains an ultraviolet light absorber and covers the second electrode layer configured to cover at least a region superimposed over the organic layer, and enclosing the organic layer with the first substrate to block the organic layer from ambient air.
[5] The organic electroluminescent device according to the above [4], having a top emission structure in which light generated by the organic light-emitting layer is emitted from a side of the second electrode.
[6] The organic electroluminescent device according to the above [4] or [5], wherein the sealing film has a film containing an inorganic compound and a film containing an organic compound.
[7] The organic electroluminescent device according to the any one of above [4] to [6], wherein the sealing film includes a deposited polymer film.
[8] A method for manufacturing an organic electroluminescent device, comprising the steps of:
   forming a first electrode on a first substrate as a supporting substrate;
   forming an organic layer including at least an organic light-emitting layer on a mounting surface of the first electrode;
   forming a second electrode on the organic layer;
   forming a resin layer containing an ultraviolet light absorber, over the second electrode, configured to cover at least a region superimposed over the organic layer; and
   forming a second substrate that covers the resin layer and encloses the organic layer with the first substrate to block the organic layer from ambient air.
[9] A method for manufacturing an organic electroluminescent device, comprising the steps of:
   forming a first electrode on a mounting surface of a first substrate as a supporting substrate;
   forming an organic layer including an organic light-emitting layer on the first electrode;
   forming a second electrode on the organic layer; and
   sealing to block the organic layer from ambient air by enclosing the organic layer with the first substrate and a sealing film having a region that contains an ultraviolet light absorber, the region putting over the second electrode and covering at least a region superimposed over the organic layer.

### EFFECT OF THE INVENTION

According to the present invention, a resin layer includes an ultraviolet light absorber that absorbs ultraviolet light, and thus ultraviolet light passing through a second substrate as the light emission side can be absorbed by the ultraviolet light absorber. Accordingly, the entry of ultraviolet light through the second substrate as the light emission side into the organic layer is effectively reduced, making it possible to remarkably improve light resistance of the organic EL device. Therefore, the present invention can achieve the goal to provide an organic EL device having excellent light resistance and having excellent light emission life such that reduction of the light emission life due to ultraviolet light passing through a second substrate as the light emission side is effectively suppressed.

### BRIEF DESCRIPTION OF DRAWINGS

[Fig. 1] Fig. 1 depicts a schematic structure of an organic EL device according to a first embodiment of the present invention.
[Fig. 2] Fig. 2 depicts another schematic structure of the organic EL device according to the first embodiment of the present invention.
[Fig. 3] Fig. 3 depicts a schematic structure of an organic EL device according to a second embodiment of the present invention.

### EXPLANATIONS OF LETTERS OR NUMERALS

- 11: first substrate
- 13: organic EL element
- 15: binder (resin layer)
- 17: second substrate
- 21: space adjusting member (spacer)
- 100: sealing layer (sealing film)
- 101: first inorganic layer (inorganic film)
- 103: first organic layer (organic film)
- 105: second inorganic layer (inorganic film)
- 107: second organic layer (organic film)
- 109: third inorganic layer (inorganic film)
- 111: third organic layer (organic film)
- L: light
- R: region of organic EL element

### BEST MODE(S) FOR CARRYING OUT THE INVENTION

Embodiments of the present invention will be explained below in detail with reference to the accompanying drawings. To facilitate understanding, scales of respective members may be shown in the drawings differently from those in practice. In addition, the present invention is not limited to the following descriptions, and appropriate changes can be made within a range not departing from the scope of the present invention. In an organic EL device, members such as lead wires for electrodes are present; however, they are not directly relevant to the descriptions of the present invention and thus descriptions thereof will be omitted. For the convenience of explanations of a layer structure or the like, examples of devices shown below are described with reference to the drawings depicting the devices in which a substrate is located at the bottom; however, the organic EL element according to the present invention and the organic EL device having the organic EL element mounted thereon are not necessary to be placed in line with the up-down or right-left orientation shown in the drawings for producing or using, and the orientation may be appropriately adjusted.

### 1. First embodiment

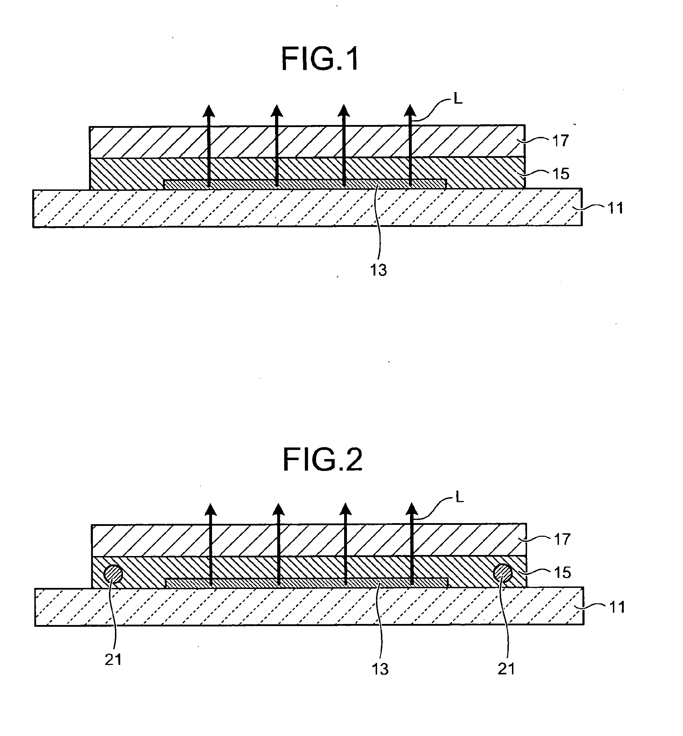

Fig. 1 is a schematic diagram of a structure of an organic EL device according to the first embodiment of the present invention. The organic EL device according to the present embodiment has a constitution which an organic EL element having an organic layer including at least an organic light-emitting layer is sandwiched between a supporting substrate and a sealing substrate, and the device has a top emission structure such that light L is emitted from a side opposite to the supporting substrate (sealing substrate side). As shown in Fig. 1, the organic EL device according to the present embodiment is composed of a first substrate 11, an organic EL element 13, a binder (resin layer) 15, and a second substrate 17.

### 1.1 First substrate

The first substrate 11, which is a plate-form substrate, is a supporting substrate having the organic EL element 13 formed on a mounting surface which is one plane surface of the substrate. With respect to the first substrate 11 used in the organic EL device according to the present embodiment, any material that forms an electrode and do not change during the formation of layers of organic materials may be used. For example, glass, plastic, a polymer film, a silicon substrate, or a stacked material obtained therefrom is used.

### 1.2 Structure of organic EL element

The organic EL element 13 according to the present embodiment has a structure having at least one light emitting layer between electrodes with a pair of an anode (first electrode) and a cathode (second electrode) in which at least the cathode is transparent or semitransparent such that it has light transmission properties, and at least one of a low-molecular organic luminescent material and a high-molecular organic luminescent material are used in the light emitting layer.

In the organic EL element, examples of layers other than the cathode, anode, and light emitting layer may include: a layer provided between the cathode and the light emitting layer; and a layer provided between the anode and the light emitting layer. Examples of layers provided between the cathode and the light emitting layer may include a charge injection layer, a charge transport layer, and a charge block layer. Examples of charge injection layers may include an electron injection layer and a hole injection layer. Examples of charge transport layers may include an electron transport layer and a hole transport layer. Examples of charge block layers may include an electron block layer and a hole block layer.

The electron injection layer is a layer having a function to improve the electron injection efficiency from the cathode. The electron transport layer is a layer having a function to improve the electron injection from the electron injection layer or the electron transport layer closer to the cathode. When the electron injection layer or the electron transport layer has a function to block the transport of holes, these layers may be also referred to as "hole block layer." The function of the layer to block the transport of holes can be confirmed by, for example, the reduction of a current of an element produced so that only a hole current flows the element.

Layers that may be provided between the anode and the light emitting layer include a hole injection layer, a hole transport layer, an electron block layer and the like.

The hole injection layer is a layer having a function to improve the hole injection efficiency from the cathode. The hole transport layer is a layer having a function to improve the hole injection from the hole injection layer or the hole transport layer closer to the anode. When the hole injection layer or the hole transport layer has a function to block the transport of electrons, these layers may be also referred to as "electron block layer." The function of the layer to block the transport of electrons can be confirmed by, for example, the reduction of a current of an element produced such that only an electron current flows the element.

Examples of the organic EL elements used in the organic EL device according to the present embodiment may include an organic EL element having a hole transport layer provided between the anode and the light emitting layer; an organic EL element having an electron transport layer provided between the cathode and the light emitting layer; and an organic EL element having an electron transport layer provided between the cathode and the light emitting layer and having a hole transport layer provided between the anode and the light emitting layer. That is, specific examples of the structure of the organic EL element may include the following structures of a) to d).
a) Anode/Light emitting layer/Cathode
b) Anode/Hole transport layer/Light emitting layer/Cathode
c) Anode/Light emitting layer/Electron transport layer/Cathode
d) Anode/Hole transport layer/Light emitting layer/Electron transport layer/Cathode
(symbol "/" indicates that the layers are adjacent to each other and stacked. The same applies to (e) to (p) mentioned below.)

The light emitting layer refers to a layer having a function to emit light. The hole transport layer refers to a layer having a function to transport holes. The electron transport layer refers to a layer having a function to transport electrons. The electron transport layer and hole transport layer are collectively referred to as "charge transport layer". Each of the light emitting layer, the hole transport layer, and the electron transport layer, may independently employ two or more layers. Among the charge transport layers provided adjacent to the electrode, particularly, one having a function to improve the charge injection efficiency from the electrode and an effect of lowering the drive voltage of the element is generally referred to as "charge injection layer (hole injection layer or electron injection layer)."

To enhance the adhesion to the electrode or to improve the charge injection from the electrode, the charge injection layer adjacent to the electrode or an insulating layer having a thickness equal to or less than 2 nanometers adjacent to the electrode may be provided. Further, to improve the adhesion at the interface or to prevent the layers from mixing together at the interface, a thin buffer layer may be inserted into the interface between the electrode and the charge transport layer or light emitting layer. The order and number of the layers to be stacked and the thickness of each layer may be appropriately selected depending on the desired light emission efficiency or element life.

Further, examples of the organic EL elements used in the organic EL device according to the present embodiment may include an organic EL element having a charge injection layer (electron injection layer or hole injection layer) provided thereon; an organic EL element having a charge injection layer (electron injection layer) provided adjacent to the cathode; and an organic EL element having a charge injection layer (hole injection layer) provided adjacent to the anode. Specific examples may include the following structures of e) to p).
e) Anode/Charge injection layer/Light emitting layer/Cathode
f) Anode/Light emitting layer/Charge injection layer/Cathode
g) Anode/Charge injection layer/Light emitting layer/Charge injection layer/Cathode
h) Anode/Charge injection layer/Hole transport layer/Light emitting layer/Cathode
i) Anode/Hole transport layer/Light emitting layer/Charge injection layer/Cathode
j) Anode/Charge injection layer/Hole transport layer/Light emitting layer/Charge injection layer/Cathode
k) Anode/Charge injection layer/Light emitting layer/Charge transport layer/Cathode
l) Anode/Light emitting layer/Electron transport layer/Charge injection layer/Cathode
m) Anode/Charge injection layer/Light emitting layer/Electron transport layer/Charge injection layer/Cathode
n) Anode/Charge injection layer/Hole transport layer/Light emitting layer/Charge transport layer/Cathode
o) Anode/Hole transport layer/Light emitting layer/Electron transport layer/Charge injection layer/Cathode
p) Anode/Charge injection layer/Hole transport layer/Light emitting layer/Electron transport layer/Charge injection layer/Cathode

In the examples of layer structures shown through a) to p) mentioned above, there may be employed either a mode in which the anode is provided on the side closer to the substrate or a mode in which the cathode is provided on the side closer to the substrate.

The organic layer in the organic electroluminescent device of the present invention may include a layer other than the organic light-emitting layer. Specific examples include layers such as a hole injection layer containing an organic compound, a hole transport layer containing an organic compound, an electron injection layer containing an organic compound, an electron transport layer containing an organic compound, a hole block layer containing an organic compound, and an electron block layer containing an organic compound. The organic layer may be provided directly on the first electrode or provided on the first electrode via another layer. Examples of the layers provided between the first electrode and the organic layer may include layers such as a hole injection layer consisting of an inorganic compound and an electron injection layer containing an inorganic compound.

### 1.3 Anode

With respect to the anode as the first electrode of the organic EL element according to the present embodiment, for example as a transparent electrode or semitransparent electrode, a thin film formed of a metal oxide, metal sulfide, or metal having high electric conductivity may be used. With respect to the thin film used as an electrode, one having high light transmittance may be preferably used, and the thin film may be appropriately selected depending on the organic layer to be used. Specifically, a film (for example, NESA) prepared with electrically conductive glass made from indium oxide, zinc oxide, tin oxide, or a composite thereof such as indium tin oxide (ITO) or indium zinc oxide; gold; platinum; silver; or copper may be used, and preferred is ITO, indium zinc oxide, or tin oxide. Examples of methods for producing include a vacuum deposition method, a sputtering method, an ion plating method, and a plating method. Alternatively, as the anode, an organic transparent conducting film of polyaniline or a derivative thereof, or polythiophene or a derivative thereof may be used.

The thickness of the anode may be appropriately selected depending on the conditions including the light transmission properties and electric conductivity. The thickness of the anode is in the range of, for example, 10 nanometers to 10 micrometers, preferably 20 nanometers to 1 micrometer, and further preferably 50 nanometers to 500 nanometers.

### 1.4 Hole injection layer

The hole injection layer may be provided between the anode and the hole transport layer, or between the anode and the light emitting layer. Examples of materials for forming the hole injection layer may include phenylamines; starburst amines; phthalocyanines; oxides such as vanadium oxide, molybdenum oxide, ruthenium oxide, and aluminum oxide; amorphous carbon; polyaniline; and polythiophene derivatives.

### 1.5 Hole transport layer

Examples of hole transport materials may include: polyvinylcarbazole and derivatives thereof; polysilane and derivatives thereof; polysiloxane derivatives having an aromatic amine at the side chain or principal chain thereof; pyrazoline derivatives; arylamine derivatives; stilbene derivatives; triphenyldiamine derivatives; polyaniline and derivatives thereof; polythiophene and derivatives thereof; polyarylamine and derivatives thereof; polypyrrole and derivatives thereof; poly(p-phenylenevinylene) and derivatives thereof; and poly(2,5-thienylenevinylene) and derivatives thereof.

Among them, the preferable hole transport material used for the hole transport layer may include high-molecular hole-transport materials such as polyvinylcarbazole and derivatives thereof; polysilane and derivatives thereof; polysiloxane derivatives having an aromatic amine at the side chain or principal chain thereof; polyaniline and derivatives thereof; polythiophene and derivatives thereof; polyarylamine and derivatives thereof; poly(p-phenylenevinylene) and derivatives thereof; and poly(2,5-thienylenevinylene) and derivatives thereof, and then further preferred are polyvinylcarbazole and derivatives thereof, polysilane and derivatives thereof, and polysiloxane derivatives having an aromatic amine at the side chain or principal chain thereof. When a low-molecular hole-transport material is employed, it is preferably in the form of a dispersion in which the hole transport material is dispersed in a polymer binder.

### 1.6 Light emitting layer

In the present invention, the light emitting layer is an organic light-emitting layer, and generally has an organic compound (a small compound or a large compound) that emits mainly fluorescence or phosphorescence. The light emitting layer may further include a dopant material. Examples of materials usable for forming the light emitting layer in the present invention may include the following materials.

### (1) Dye materials

Examples of dye materials may include cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, triphmanylamine derivatives, oxadiazole dimers, and a pyrazoline dimer.

### (2) Metal complex materials

Examples of metal complex materials may include metal complexes emitting from the triplet excited state such as iridium complexes and platinum complexes; and metal complexes such as aluminum quinolinol complexes, benzoquinolinol beryllium complexes, benzoxazolyl zinc complexes, benzothiazole zinc complexes, azomethyl zinc complexes, porphyrin zinc complexes, and europium complexes, which are complexes having Al, Zn, Be, or rare earth metals such as Tb, Eu, or Dy as the central metal and having oxadiazole, thiadiazole, phenylpyridine, phenylbenzoimidazole, or quinoline structure as the ligand.

### (3) Polymer materials

Polymer materials may include polyparaphenylenevinylene derivatives, polythiophene derivatives, polyparaphenylene derivatives, polysilane derivatives, polyacetylene derivatives, polyfluorene derivatives, polyvinylcarbazole derivatives, and polymers formed from the above described dye or metal-complex luminescent materials.

Among luminescent materials, examples of materials emitting blue light may include distyrylarylene derivatives, oxadiazole derivatives, and polymers thereof; polyvinylcarbazole derivatives; polyparaphenylene derivatives; polyfluorene derivatives; quinacridone derivatives; and coumarin derivatives. Among these, preferred are polymer materials of polyvinylcarbazole derivatives, polyparaphenylene derivatives, and polyfluorene derivatives.

Examples of materials emitting green light may include quinacridone derivatives, coumarin derivatives, and polymers thereof; polyparaphenylenevinylene derivatives; and polyfluorene derivatives. Among these, preferred are polymer materials of polyparaphenylenevinylene derivatives and polyfluorene derivatives.

Examples of materials emitting red light may include coumarin derivatives, thiophene ring compounds, and polymers thereof; polyparaphenylenevinylene derivatives; polythiophene derivatives; and polyfluorene derivatives. Among these, preferred are polymer materials of polyparaphenylenevinylene derivatives, polythiophene derivatives, or polyfluorene derivatives.

### (2) Dopant material

For example, to improve the light emission efficiency or to change the light emission wavelength, a dopant may be added to the light emitting layer. Examples of such dopants may include perylene derivatives, coumarin derivatives, rubrene derivatives, quinacridone derivatives, squarylium derivatives, porphyrin derivatives, styryl dyes, tetracene derivatives, pyrazolone derivatives, decacyclene, and phenoxazone.

### 1.7 Electron transport material

With respect to the electron transport material, a material conventionally known as an electron transport material may be used, and examples of such materials may include oxadiazole derivatives; anthraquinodimethane or derivatives thereof; benzoquinone or derivatives thereof; naphthoquinone or derivatives thereof; anthraquinone or derivatives thereof; tetracyanoanthraquinodimethane or derivatives thereof; fluorenone derivatives; diphenyldicyanoethylene or derivatives thereof; diphenoquinone derivatives; or 8-hydroxyquinoline or metal complexes of its derivatives; polyquinoline and derivatives thereof; polyquinoxaline and derivatives thereof; and polyfluorene and derivatives thereof.

Among them, preferred are oxadiazole derivatives; benzoquinone or derivatives thereof; anthraquinone or derivatives thereof; or 8-hydroxyquinoline or metal complexes of its derivatives; polyquinoline or derivatives thereof; polyquinoxaline or derivatives thereof; and polyfluorene or derivatives thereof, and then further preferred are 2-(4-biphenylyl)-5-(4-t-butylphenyl)-1,3,4-oxadiazole, benzoquinone, anthraquinone, tris(8-quinolinol)aluminum, and polyquinoline.

### 1.8 Electron injection layer

The electron injection layer is provided between the electron transport layer and the cathode, or between the light emitting layer and the cathode. According to the type of the light emitting layer, the following electron injection layers may be provided: an electron injection layer consisting of a monolayer structure of a Ca layer; or an electron injection layer consisting of a stacked structure that is composed of a Ca layer and a layer formed from any one or more members of metals belonging to Group IA and Group IIA of the Periodic Table except Ca and having a work function of 1.5 to 3.0 eV, and oxides, halides, and carbonates of the above mentioned metals. Examples of the metals that have a work function of 1.5 to 3.0 eV and belong to Group IA of the Periodic Table or oxides, halides, or carbonates of those metals may include lithium, lithium fluoride, sodium oxide, lithium oxide, and lithium carbonate. Examples of the metals that have a work function of 1.5 to 3.0 eV and belong to Group IIA of the Periodic Table excluding Ca, or oxides, halides, or carbonates of those metals may include strontium, magnesium oxide, magnesium fluoride, strontium fluoride, barium fluoride, strontium oxide, and magnesium carbonate.

### 1.9 Cathode

The cathode as the second electrode of the organic EL element according to the present embodiment, as a transparent electrode or semitransparent electrode, the following materials may be used: metal; graphite or graphite intercalation compounds; inorganic semiconductors such as ZnO (zinc oxide); conducting transparent electrodes such as ITO (indium tin oxide) and IZO (indium zinc oxide); and metal oxide such as strontium oxide or barium oxide. Examples of metals may include: alkali metals such as lithium, sodium, potassium, rubidium, and cesium; alkaline earth metals such as beryllium, magnesium, calcium, strontium, and barium; transition metals such as gold, silver, platinum, copper, manganese, titanium, cobalt, nickel, and tungsten; tin, aluminum, scandium, vanadium, zinc, yttrium, indium, cerium, samarium, europium, terbium, and ytterbium; and alloys composed of the two or more metals mentioned above. Examples of alloys may include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys. The cathode may have a stacked structure composed of two or more layers. Examples of the stacked structures may include stacked structures of the metal mentioned above, metal oxide, fluoride, alloy thereof, and a metal such as aluminum, silver, and chromium.

### 1.10 Binder (Resin layer)

In the present embodiment, a layer containing an ultraviolet light absorber is provided to cover the organic EL element. It is sufficient if the layer containing an ultraviolet light absorber, which is put over the electrode, covers a region superimposed over the organic layer containing at least an organic light-emitting layer. It is a preferred mode that the entire organic EL element is enclosed with the layer containing an ultraviolet light absorber and the supporting substrate.

As shown in Fig. 1, the binder (resin layer) 15 is a binder (thermosetting resin) that bonds together the first substrate 11 and the second substrate 17 and fills the space between the first substrate 11 and the second substrate 17 without any gap. By the binder (resin layer) 15 filling the space, an effect of improving the efficiency of light emission in the organic EL device can be obtained.

Furthermore, the binder (resin layer) 15 according to the present embodiment contains an ultraviolet light absorber that absorbs ultraviolet light.
Since the binder (resin layer) 15 contains an ultraviolet light absorber, ultraviolet light striking the second substrate 17 as the light emission side can be absorbed by the ultraviolet light absorber. Thus, in the organic EL device according to the present embodiment, the ultraviolet light is effectively prevented from passing through the second substrate 17 as the light emission side and going into the light emitting layer and other organic layers of the organic EL element 13, making it possible to remarkably improve the organic EL device in light resistance, leading to the increase of the light emission life.

Examples suitable for the ultraviolet light absorbers may include materials based on benzophenone, benzotriazole, triazine, or phenyl salicylate. Specifically, more preferred is a material having one or more compounds selected from the group consisting of 2,4-dihydroxybenzophenone, 2-hydroxy-4-methoxybenzophenone, 4-dodecyloxy-2-hydroxybenzophenone, 2-hydroxy-4-methoxy-5-sulfobenzophenone, 2(2'-hydroxy-5-methylphenyl)benzotriazole, 2(2'-hydroxy-3',5'-ditertiarybutyl)benzotriazole, phenyl salicylate, p-octylphenyl salicylate, and p-tertiarybutylphenyl salicylate. These ultraviolet light absorbers may be used independently, and two or more of them may be used in combination.

The amount of the ultraviolet light absorber included in the binder (resin layer) 15 is 1% by weight to 90% by weight, preferably 20% by weight to 60% by weight. The ultraviolet light absorber may be partially dispersed in the binder (resin layer) 15, and, in this case, it is preferred that the ultraviolet light absorber in the binder (resin layer) 15 is arranged at least in a region over the light emitting layer and other organic layers of the organic EL element 13. Thus, the ultraviolet light passing through the second substrate 17 as the light emission side and going into the light emitting layer and other organic layers can be absorbed by the ultraviolet light absorber.

When the ultraviolet light absorber is substantially uniformly dispersed in the binder (resin layer) 15, the binder (resin layer) 15 is arranged at least in a region over the light emitting layer and other organic layers of the organic EL element 13, and a general binder (a thermosetting resin or an ultraviolet curing resin) may be arranged on the outer edge of the region to bond together the first substrate 11 and the second substrate 17. Also in this case, the ultraviolet light passing through the second substrate 17 as the light emission side and going into the light emitting layer and other organic layers can be absorbed by the ultraviolet light absorber.

When the ultraviolet light absorber is partially dispersed in the binder (resin layer) 15, by arranging the ultraviolet light absorber in the binder (resin layer) 15 at least in a part of a region on the light emitting layer and other organic layers of the organic EL element 13, the effect of the present invention can be obtained. However, to uniformly and surely absorb the ultraviolet light going into the light emitting layer and other organic layers, it is preferred that the ultraviolet light absorber is arranged to cover a region over the light emitting layer and other organic layers of the organic EL element 13. In addition, the ultraviolet light absorber in the binder (resin layer) 15 is arranged at a region wider than that covering the light emitting layer and other organic layers of the organic EL element 13, and thereby ultraviolet light coming from oblique directions can also be more surely absorbed.

Likewise, when the ultraviolet light absorber is substantially uniformly dispersed in the binder (resin layer) 15, by arranging the binder (resin layer) 15 at least in a part of a region on the light emitting layer and other organic layers of the organic EL element 13, the effect of the present invention can be obtained. However, to uniformly and surely absorb the ultraviolet light going into the light emitting layer and other organic layers, it is preferred that the binder (resin layer) 15 is arranged to cover a region over the light emitting layer and other organic layers of the organic EL element 13. In addition, the binder (resin layer) 15 is arranged at a region wider than that covering the light emitting layer and other organic layers of the organic EL element 13, and thereby ultraviolet light coming from oblique directions can also be more surely absorbed. Fig. 1 depicts an example in which the ultraviolet light absorber is substantially uniformly dispersed in the binder (resin layer) 15 and the binder (resin layer) 15 is arranged over the entire surface of the second substrate 17.

As a modification example of the binder (resin layer) 15 according to the present embodiment, as shown in Fig. 2, a space adjusting member (spacer) 21 that adjusts the space between the first substrate 11 and the second substrate 17 may be included near the outer edge in the binder (resin layer) 15. By incorporating the space adjusting member (spacer) 21, the space between the first substrate 11 and the second substrate 17 is not reduced to a predetermined size or smaller.

### 1.11 Second substrate

The second substrate 17 is a sealing substrate, which is attached to the first substrate 11 with the binder (resin layer) 15 to block the organic layer from ambient air. For the second substrate 17 in the organic EL device according to the present embodiment, any materials capable of blocking the organic layer from ambient air may be used, and examples thereof may include glass, plastic, a polymer film, a silicon substrate, and a stacked structure obtained therefrom. In the organic EL device, members such as lead wires for the electrodes are present; however, they are not directly relevant to the present invention, and thus descriptions thereof are omitted.

### 1.12 Method for manufacturing organic EL device according to the first embodiment

A method for manufacturing the organic EL device mentioned above is described below. Chromium (Cr) and indium tin oxide (ITO), for example, are first stacked in this order on the first substrate 11 by a known method, and patterned to form a first electrode. Then, surface cleaning treatment on the ITO was performed by a UV-ozonization apparatus.

Next, a solution containing a material for hole injection layer is applied to the first electrode by, for example, a spin coating method and dried to form a hole injection layer. Subsequently, a solution containing a luminescent material is applied to the hole injection layer by, for example, a spin coating method and dried to produce a light emitting layer, thereby forming an organic EL layer.

Next, for example, a barium (Ba) layer and an aluminum (Al) layer are formed on the organic EL layer by a vacuum deposition method. Further, indium tin oxide (ITO) is deposited on the aluminum layer by a facing-target deposition apparatus using indium tin oxide (ITO) as a target to form an ITO transparent electrode layer as a second electrode. Thus, the organic EL element 13 is formed on the first substrate 11.

Next, the epoxy thermosetting binder 15 having mixed therein an ultraviolet light absorber such as 2-hydroxy-4-octoxybenzophenone in an amount of, for example, about 20% by weight is then applied to the entire surface of the second substrate 17 on the side to be attached to the first substrate. The resultant second substrate and the prepared first substrate are put on positions so that the side of the second substrate 17 onto which the thermosetting binder 15 is applied and the side of the first substrate 11 on which the organic EL element 13 are faced each other, and they are adjusted to predetermined positions so that the emission region of the organic EL element 13 is blocked from ambient air, and then they are attached together.

Heating treatment is then performed to the resultant material in an oven at a temperature of 80°C for 2 hours to cure the thermosetting binder 15 to bond the first substrate having the organic EL element 13 formed thereon and the second substrate together, thereby producing the organic EL device according to the present embodiment.

As necessary, as a barrier film for protecting the organic EL element 13 from the binder (resin layer) 15, for example, a silicon nitride film having a thickness of about 200 nanometers may be formed by a chemical vapor deposition (CVD) method so that the film covers the organic EL element 13.

As described above, in the organic EL device according to the present embodiment, since the binder (resin layer) 15 contains an ultraviolet light absorber that absorbs ultraviolet light, ultraviolet light approaching from the second substrate 17 as the light emission side can be absorbed by the ultraviolet light absorber; thus, in the organic EL device according to the present embodiment, the ultraviolet light is effectively prevented from passing through the second substrate 17 as the light emission side and going into the light emitting layer and other organic layers of the organic EL element 13, making it possible to remarkably improve the organic EL device in light resistance. Therefore, the organic EL device according to the present embodiment can be such a device having excellent light resistance, achieving excellent light emission life such that the reduction of the light emission life caused due to ultraviolet light coming from the second substrate 17 as the light emission side is effectively suppressed.

### 2. Second embodiment

### 2.1 Structure of organic EL device according to second embodiment

In the second embodiment, an organic EL device having, instead of the second substrate as a sealing substrate, a sealing layer (sealing film) that blocks the organic EL element from ambient air is described.

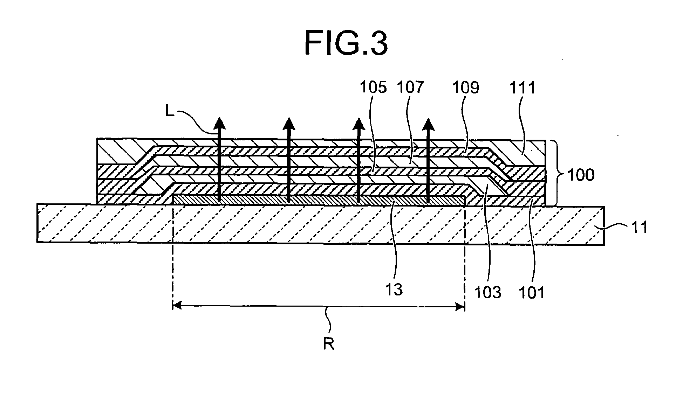

Fig. 3 depicts a schematic structure of an organic EL device according to the second embodiment of the present invention. The organic EL device according to the present embodiment is an organic EL device having a structure such that the organic EL device has sandwiched between a supporting substrate and a sealing layer an organic EL element having an organic layer, and having a top emission structure in which light is emitted from the side opposite the supporting substrate (sealing layer side). As shown in Fig. 3, the organic EL device according to the present embodiment is composed of the first substrate 11, the organic EL element 13, and a sealing layer (sealing film) 100.

A difference between the organic EL device according to the present embodiment and the organic EL device according to the first embodiment shown in Fig. 1 is that the device according to the present embodiment has a sealing layer (sealing film) instead of the second substrate as a sealing substrate. Except for this, in the present embodiment and the first embodiment, like parts are denoted by like reference numerals, and descriptions thereof are referred to those in the first embodiment described above, and thus detailed descriptions thereof will be omitted. The sealing layer (sealing film) 100 according to the present embodiment is described below in detail.

The sealing layer (sealing film) 100 according to the present embodiment has a function to block the organic EL element from ambient air, and is transparent or semitransparent such that it has light transmission properties. The sealing layer (sealing film) 100 is, as shown in Fig. 3, a multilayer film having a first inorganic layer (inorganic film) 101, a first organic layer (organic film) 103, a second inorganic layer (inorganic film) 105, a second organic layer (organic film) 107, a third inorganic layer (inorganic film) 109, and a third organic layer (organic film) 111, which are stacked on one another. Each of the first to third inorganic layers (inorganic films) 101, 105, and 109 and the first to third organic layers (organic films) 103, 107, and 111 has a function to block the organic EL element from ambient air.

The first to third inorganic layers (inorganic films) 101, 105, and 109 in the defect-free state can achieve high air blocking properties even when they are thin films. However, it is difficult to obtain an inorganic layer (inorganic film) in the completely defect-free state. Therefore, the sealing layer (sealing film) 100 has a structure such that an inorganic layer (inorganic film) and an organic layer (organic film) are alternately stacked and the organic layer (organic film) blocks a passage of the penetration of moisture or oxygen to improve the overall air blocking properties.

In the sealing layer (sealing film) 100, the areas of the first to third inorganic layers (inorganic films) 101, 105, and 109 are made larger than the areas of the first to third organic layers (organic films) 103, 107, and 111;therefore, moisture is prevented from going into the organic EL device in the direction from the side of the organic EL device (in the direction substantially parallel with the first substrate).

Further, the sealing layer (sealing film) 100 contains an ultraviolet light absorber that absorbs ultraviolet light at the first to third organic layers (organic films) 103, 107, and 111. Since the first to third organic layers (organic films) 103, 107, and 111 contain an ultraviolet light absorber, ultraviolet light coming from the second substrate 17 as the light emission side can be absorbed by the ultraviolet light absorber. Thus, in the organic EL device according to the present embodiment, the ultraviolet light is effectively prevented from passing through the second substrate 17 as the light emission side and going into the light emitting layer and other organic layers of the organic EL element 13, making it possible to remarkably improve the organic EL device in light resistance, leading to the increase of the light emission life.

For the ultraviolet light absorber, the same ultraviolet light absorber as that in the first embodiment may be used. The ultraviolet light absorber may be included in either one of or all of the first to third organic layers (organic films) 103, 107, and 111. When the ultraviolet light absorber is included in the first organic layer or second organic layer, a layer containing the ultraviolet light absorber can be provided at least in a region R covering an upper surface of the organic EL element 13. From the viewpoint of more surely obtaining the effect of absorbing ultraviolet light, it is preferred that the ultraviolet light absorber is included in all of the first to third organic layers.

Preferred examples of inorganic layer materials usable for forming the inorganic layer (inorganic film) in the sealing layer (sealing film) 100 may include aluminum oxide, silicon oxide, silicon nitride, silicon nitride oxide and the like. As a method for forming the inorganic layer, methods such as a sputtering method, a plasma CVD method may be applied.

Examples of organic layer materials usable for forming the organic layer (organic film) in the sealing layer (sealing film) 100 may include acrylic compounds. An organic monomer having a (meth)acryl group has excellent adhesion properties to an layer of inorganic compounds such as silicon oxide or aluminum oxide and is preferably used as a binder. Further, methyl methacrylate having high transparency is preferably used in the organic EL device of a top emission structure.

The acrylic compounds refer to compounds having a group derived from acrylic acid or derivatives thereof. The type of the acrylic compounds is not particularly limited, and a compound having in its molecule at least one (meth)acryl group may be used as an organic layer material. When using a compound having one (meth)acryl group, a layer having higher adhesion to the inorganic compound layer can be obtained. When using a compound having two or three (meth)acryl groups, an organic layer becomes to have a higher crosslink density, thereby increasing film strength of the organic layer. Polymerization of the organic monomer may be carried out by irradiation with any of electron beam, plasma, and ultraviolet light, or by a heating treatment.

A film of the acrylic compound is generally formed by a method in which a solution having an organic compound dispersed in a solvent is applied by a method such as spin coating and cured using light. However, according to the type of the organic compound, a method such as flash deposition may be used.

As such acrylic compound, a monofunctional (meth)acrylate or a difunctional or polyfunctional acrylic compound may be used, and there is no particular limitation. Examples of the acrylic compounds may include acrylic monofunctional compounds: compounds having a hydroxyl group such as 2-hydroxyethyl (meth)acrylate, 2-hydroxypropyl (meth)acrylate, and 2-hydroxybutyl (meth)acrylate; compounds having an amino group such as dimethylaminoethyl (meth)acrylate and diethylaminoethyl (meth)acrylate; compounds having a carboxyl group such as (meth)acrylic acid, 2-(meth)acryloyloxyethyl succinate, and 2-(meth)acryloyloxyethyl hexahydrophthalate; (meth)acrylates having a cyclic skeleton such as glycidyl (meth)acrylate, tetrahydrofurfuryl (meth)acrylate, cyclohexyl (meth)acrylate, phenoxyethyl (meth)acrylate, and isobornyl (meth)acrylate; and isoamyl (meth)acrylate, lauryl (meth)acrylate, stearyl (meth)acrylate, butoxyethyl (meth)acrylate, ethoxy diethylene glycol (meth)acrylate, methoxy triethylene glycol (meth)acrylate, and methoxy dipropylene glycol (meth)acrylate. Examples of difunctional compounds may include acrylic difunctional compounds such as diethylene glycol di(meth)acrylate, 1,4-butanediol di(meth)acrylate, 1,6-hexanediol di(meth)acrylate, 1,9-nonanediol di(meth)acrylate, triethylene di(meth)acrylate, polyethylene glycol di(meth)acrylate, neopentyl di(meth)acrylate, and dimethylol tricyclodecanedi(meth)acrylate, and difunctional acrylic compounds such as difunctional epoxy (meth)acrylate and difunctional urethane (meth)acrylate. Examples of compounds having three or more (meth)acryl groups may include acrylic polyfunctional monomers such as dipentaerythritol hexa(meth)acrylate, pentaerythritol tri(meth)acrylate, pentaerythritol tetra(meth)acrylate, trimethylolpropane tri(meth)acrylate, and trimethylolpropane tetra(meth)acrylate; and polyfunctional compounds such as (meth)acrylic polyfunctional epoxy acrylate and (meth)acrylic polyfunctional urethane acrylate.

The sealing layer (sealing film) 100 may include a deposited polymer film.

### 2.2 Method for manufacturing organic EL device according to the second embodiment

A method for manufacturing the organic EL device mentioned above is described below. First, chromium (Cr) and indium tin oxide (ITO) are stacked in this order on the first substrate 11 by a known method, and patterned to form a first electrode. Then, surface cleaning treatment on the ITO is performed by a UV-ozonization apparatus. A solution containing a material for hole injection layer is applied to the first electrode by, for example, a spin coating method and dried to form a hole injection layer. Subsequently, a solution containing a luminescent material is applied to the hole injection layer by, for example, a spin coating method and dried to form a light emitting layer, obtaining an organic EL layer.

Next, for example, a barium (Ba) layer and an aluminum (Al) layer are formed on the organic EL layer by a vacuum deposition method. Further, indium tin oxide (ITO) is deposited on the aluminum (Al) layer by a facing-target deposition apparatus using indium tin oxide (ITO) as a target to form an ITO transparent electrode layer as a second electrode. Thus, the organic EL element 13 is formed on the first substrate 11.

After producing the organic EL element 13, the first substrate 11 is transferred from the vapor deposition chamber to a film sealing apparatus without being exposed to ambient air. A mask is then aligned on the first substrate 11. The first substrate 11 is transferred to an inorganic film-forming chamber, and a transparent and flat film of aluminum oxide is formed on the surface of the first substrate 11 by a sputtering method, for example, to cover the organic EL element 13. Thus, the first inorganic layer (inorganic film) 101 is obtained.

After forming the first inorganic layer (inorganic film) 101, the mask is removed and the first substrate 11 is transferred to a chamber having introduced inert gas. Next, an organic monomer material having mixed therein an ultraviolet light absorber such as 2-hydroxy-4-octoxybenzophenone is applied to the first substrate 11 in an inert gas atmosphere by a spin coating method. The first substrate 11 having the organic monomer material applied thereto is then irradiated with UV light to crosslink and cure the organic monomer, obtaining the transparent and flat first organic layer (organic film) 103 containing an ultraviolet light absorber on the first inorganic layer (inorganic film) 101.

After forming the first organic layer (organic film) 103 containing an ultraviolet light absorber, the first substrate 11 is transferred to the inorganic film-forming chamber, and the second inorganic layer (inorganic layer) 105 is formed on the first organic layer (organic film) 103 in the same manner as in the first inorganic layer (inorganic film) 101. After forming the second inorganic layer (inorganic film) 105, the second organic layer (organic film) 107 containing an ultraviolet light absorber is formed on the second inorganic layer (inorganic film) 105 in the same manner as the first organic layer (organic film) 103.

After forming the second organic layer (organic film) 107 containing an ultraviolet light absorber, the third inorganic layer (inorganic layer) 109 is formed on the second organic layer (organic film) 107 in the same manner as the first inorganic layer (inorganic film) 101. Further, after forming the third inorganic layer (inorganic film) 109, the third organic layer (organic film) 111 containing an ultraviolet light absorber is formed on the third inorganic layer (inorganic film) 109 in the same manner as the first organic layer (organic film) 103 to obtain the sealing layer (sealing film) 100, thereby producing the organic EL device according to the present embodiment. The areas of the formed first to third inorganic layers (inorganic films) 101, 105, and 109 are formed larger than those of the formed first to third organic layers (organic films) 103, 107, and 111.

### Examples

### Example 1.

In Example 1, the organic EL device having a top emission structure described above in the first embodiment is produced. Chromium (Cr) and indium tin oxide (ITO) are first stacked in this order by a known method on a transparent glass substrate as a first substrate, and patterned to form a first electrode. Then, surface cleaning treatment on the ITO is performed by a UV-ozone treatment apparatus.

Subsequently, an aqueous solution of PEDOT/PPS (Baytron P (product name), by Bayer AG) as a material for hole injection layer is applied by a spin coating method, and the applied aqueous solution is dried to form a hole injection layer having a thickness of 100 nanometers. A 1% by weight toluene-anisole mixture solution of MEH-PPV (poly(2-methoxy-5-(2'-ethyl-hexyloxy)-paraphenylenevinylene)), by Aldrich Corporation, having a weight average molecular weight of about 200,000 as a luminescent material is prepared. The mixture solution is applied by a spin coating method, and the applied mixture solution is dried to form a light emitting layer having a thickness of 100 nanometers, thereby producing an organic EL layer.

Next, a barium (Ba) layer having a thickness of 5 nanometers is formed by a vacuum vapor deposition method, and a aluminium (Al) layer having thickness 10 nanometers is formed on the barium layer by a vacuum deposition method. Further, indium tin oxide (ITO) is deposited on the aluminum (Al) layer by a facing-target deposition apparatus using indium tin oxide (ITO) as a target so that the thickness of the deposited film becomes 150 nanometers to form an ITO transparent electrode layer as a second electrode, thereby forming an organic EL element on the transparent glass substrate as a first substrate. As a barrier film for protecting the organic EL element from the binder (resin layer), a silicon nitride film having a thickness of 200 nanometers is formed by a CVD method.

Next, an epoxy thermosetting binder having mixed therein 2-hydroxy-4-octoxybenzophenone (product name: Sumisorb 130, by Sumitomo Chemical Co., Ltd.) as an ultraviolet light absorber in an amount of 20% by weight is then applied to the entire surface of a transparent glass substrate for sealing as a second substrate on the side to be attached to the first substrate. The resultant second substrate and the prepared first substrate are put on positions so that the side of the second substrate onto which the thermosetting binder is applied and the side of the first substrate on which the organic EL element are faced each other, and they are adjusted to predetermined positions and attached together so that the emission region of the organic EL element is blocked from ambient air.

Heating treatment on the resultant product is performed in an oven at a temperature of 80°C for 2 hours to cure the thermosetting binder, so that the first substrate having the organic EL element formed thereon and the second substrate are bonded together, thereby producing an organic EL device in the Example 1.

### Comparative Example 1.

The organic EL device of Comparative Example 1 is produced according to the same condition as that in the Example 1 except that 2-hydroxy-4-octoxybenzophenone as an ultraviolet light absorber is not mixed into the epoxy thermosetting binder.

### (Evaluation)

With respect to each of the produced organic EL devices in the Example 1 and the Comparative Example 1, the first electrode of a stacked Cr-ITO side is connected to the positive electrode, and the second electrode side formed only of ITO is connected to the negative electrode, and a direct current is applied to each device using a source meter. The results of the evaluation of life of the organic EL devices in the Example 1 and the Comparative Example 1 indicate that the light emission life of the organic EL device in the Example 1 is longer than that of the organic EL element in the Comparative Example 1.

### Example 2.

In Example 2, the organic EL device having a top emission structure described above in the second embodiment is produced. Chromium (Cr) and indium tin oxide (ITO) are first stacked in this order by a known method on a transparent glass substrate as a first substrate, and patterned to form a first electrode. Then, surface cleaning treatment on the ITO is performed by a UV-ozonization apparatus.

Next, an aqueous solution of PEDOT/PPS (Baytron P (product name), by Bayer AG) as a material for hole injection layer is then applied by a spin coating method, and the applied aqueous solution is dried to form a hole injection layer having a thickness of 100 nanometers. A 1% by weight toluene-anisole mixture solution of MEH-PPV (poly(2-methoxy-5-(2'-ethylhexyloxy)-paraphenylenevinylene)), by Aldrich Corporation, having a weight average molecular weight of about 200,000 as a luminescent material is prepared. The mixture solution is applied by a spin coating method, and the applied mixture solution is dried to form a light emitting layer having a thickness of 100 nanometers, thereby forming an organic EL layer.

Subsequently, a barium (Ba) layer having a thickness of 5 nanometers is formed by a vacuum vapor deposition method, and a aluminium (Al) layer having thickness 10 nanometers is formed on the barium layer by a vacuum deposition method. Further, indium tin oxide (ITO) is deposited on the aluminum (Al) layer by a facing-target deposition apparatus using indium tin oxide (ITO) as a target so that the thickness of the deposited film becomes 150 nanometers to form an ITO transparent electrode layer as a second electrode, thereby forming an organic EL element on the transparent glass substrate as a first substrate.

After producing the organic EL element, the first substrate is transferred from the deposition chamber to a film sealing apparatus (Guardian 200 (product name)), by VITEX SYSTEMS in the United States, without being exposed to ambient air. A mask is then aligned on the first substrate. Subsequently, the first substrate is transferred to an inorganic film-forming chamber, and a film of aluminum oxide is formed on the surface of the first substrate by a sputtering method to cover the organic EL element. The film of aluminum oxide is formed by introducing argon gas and oxygen gas into the inorganic film-forming chamber and using an aluminum metal target having a purity of 5 N, thereby obtaining a transparent and flat aluminum oxide film having a thickness of about 60 nanometers as a first inorganic layer (inorganic film).

After forming the first inorganic layer (inorganic film) 101, the mask is removed and the first substrate is transferred to a chamber having introduced inert gas. Next, an organic monomer material (product name: Vitex Barix Resin System monomer material (Vitex 701), by VITEX SYSTEMS) having mixed therein 2-hydroxy-4-octoxybenzophenone (product name: Sumisorb 130, by Sumitomo Chemical Co., Ltd.) as an ultraviolet light absorber is applied to the first substrate in an inert gas atmosphere by a spin coating method. Then, the first substrate having the organic monomer material applied thereto is irradiated with UV light to crosslink and cure the organic monomer, obtaining a transparent and flat first organic layer (organic film) containing an ultraviolet light absorber and having a thickness of about 1.3 micrometers.

After forming the first organic layer (organic film) including an ultraviolet light absorber, the first substrate is transferred to the inorganic film-forming chamber, and a second inorganic layer (inorganic layer) is formed in the same manner as the first inorganic layer (inorganic film) to obtain a transparent and flat aluminum oxide film having a thickness of about 60 nanometers.
After forming the second inorganic layer (inorganic film), the mask is removed and the first substrate is transferred to the chamber having introduced inert gas, and a film is formed in the same manner as the first organic layer (organic film) to obtain a transparent and flat second organic layer (organic film) containing an ultraviolet light absorber and having a thickness of about 1.3 micrometers.

After forming the second organic layer (organic film) containing an ultraviolet light absorber, the first substrate is transferred to the inorganic film-forming chamber, and a third inorganic layer (inorganic layer) is formed in the same manner as the first inorganic layer (inorganic film) to obtain a transparent and flat aluminum oxide film having a thickness of about 60 nanometers. After forming the third inorganic layer (inorganic film), the mask is removed and the first substrate is transferred to the chamber having introduced inert gas, and a film is formed in the same manner as the first organic layer (organic film) to obtain a transparent and flat third organic layer (organic film) containing an ultraviolet light absorber and having a thickness of about 1.3 micrometers, forming a sealing layer (sealing film), thereby producing an organic EL device in the Example 2.

### Comparative Example 2.

An organic EL device in Comparative Example 2 is produced according to the same condition as that in the Example 2 except that 2-hydroxy-4-octoxybenzophenone as an ultraviolet light absorber is not mixed into the organic monomer material.

### (Evaluation)

With respect to each of the produced organic EL devices in the Example 2 and the Comparative Example 2, the first electrode of the stacked Cr-ITO side is connected to the positive electrode, and the side of the second electrode only of ITO is connected to the negative electrode, and a direct current is applied to each device using a source meter. The results of the evaluation of life of the organic EL devices in the Example 2 and the Comparative Example 2 indicate that the light emission life of the organic EL device in the Example 2 is longer than that of the organic EL element in the Comparative Example 2.

### INDUSTRIAL APPLICABILITY

The organic EL device according to the present invention is useful for a technical field where high light resistance is required. For example, the organic EL device is useful for use under an environment where there is strong ultraviolet light such as outdoors.

## Claims

1. An organic electroluminescent device comprising:
a first substrate as a supporting substrate;
a first electrode provided on a mounting surface of the first substrate;
an organic layer that is provided on the first electrode and includes at least an organic light-emitting layer;
a second electrode provided on the organic layer;
a resin layer that contains an ultraviolet light absorber, and is provided over the second electrode to cover at least a region superimposed over the organic layer; and
a second substrate that covers the resin layer and encloses the organic layer with the first substrate to block the organic layer from ambient air.

2. The organic electroluminescent device according to claim 1, having a top emission structure in which light generated by the organic light-emitting layer is emitted from a side of the second substrate.

3. The organic electroluminescent device according to claim 1, wherein the resin layer contains a space adjusting member that adjusts a space between the first substrate and the second substrate.

4. An organic electroluminescent device comprising:
a first substrate as a supporting substrate;
a first electrode provided on a mounting surface of the first substrate;
an organic layer that is provided on the first electrode and includes at least an organic light-emitting layer;
a second electrode provided on the organic layer; and
a sealing film having a region that contains an ultraviolet light absorber and covers the second electrode layer configured to cover at least a region superimposed over the organic layer, and enclosing the organic layer with the first substrate to block the organic layer from ambient air.

5. The organic electroluminescent device according to claim 4, having a top emission structure in which light generated by the organic light-emitting layer is emitted from a side of the second electrode.

6. The organic electroluminescent device according to claim 4, wherein the sealing film has a film containing an inorganic compound and a film containing an organic compound.

7. The organic electroluminescent device according to claim 4, wherein the sealing film includes a deposited polymer film.

8. A method for manufacturing an organic electroluminescent device, comprising the steps of:
forming a first electrode on a first substrate as a supporting substrate;
forming an organic layer including at least an organic light-emitting layer on a mounting surface of the first electrode;
forming a second electrode on the organic layer;
forming a resin layer containing an ultraviolet light absorber, over the second electrode, configured to cover at least a region superimposed over the organic layer; and
forming a second substrate that covers the resin layer and encloses the organic layer with the first substrate to block the organic layer from ambient air.

9. A method for manufacturing an organic electroluminescent device, comprising the steps of:
forming a first electrode on a mounting surface of a first substrate as a supporting substrate;
forming an organic layer including an organic light-emitting layer on the first electrode;
forming a second electrode on the organic layer; and
sealing to block the organic layer from ambient air by enclosing the organic layer with the first substrate and a sealing film having a region that contains an ultraviolet light absorber, the region putting over the second electrode and covering at least a region superimposed over the organic layer.
